# EUROPEAN PATENT SPECIFICATION

(11) **EP 4 172 555 B1**
(45) Date of publication and mention of the grant of the patent: **10.04.2024**
(21) Application number: 21728916.4
(22) Date of filing: 27.05.2021
(51) Int. Cl.: G01B 9/02, G03F 7/20, G03F 9/00

(54) **A SIGNAL PARAMETER DETERMINATION METHOD, A HETERODYNE INTERFEROMETER SYSTEM, A LITHOGRAPHIC APPARATUS AND A DEVICE MANUFACTURING METHOD**
VERFAHREN ZUR BESTIMMUNG VON SIGNALPARAMETERN, HETERODYNES INTERFEROMETERSYSTEM, LITHOGRAPHISCHES GERÄT UND VERFAHREN ZUR HERSTELLUNG EINER VORRICHTUNG
PROCÉDÉ DE DÉTERMINATION DE PARAMÈTRES DE SIGNAUX, SYSTÈME INTERFÉROMÉTRIQUE À HÉTÉRODYNE, APPAREIL LITHOGRAPHIQUE ET PROCÉDÉ DE FABRICATION DE DISPOSITIFS

(30) Priority: 29.06.2020 EP 20182778
(43) Date of publication of application: 03.05.2023
(73) Proprietor: ASML Netherlands B.V., 5500 AH Veldhoven (NL)
(72) Inventor: JANSEN, Maarten, Jozef, 5500 AH Veldhoven (NL); IKKINK, Teunis, Jan, 5500 AH Veldhoven (NL)
(74) Representative: ASML Netherlands B.V.
(86) International application number: PCT/EP2021/064239
(87) International publication number: WO 2022/002497

(56) References cited:
- US-A- 5 106 192
- US-A1- 2013 100 458
- US-A1- 2014 307 263

## Description

### FIELD

The present invention relates to a method to determine one or more signal parameters of each signal of interest in a plurality of signals of interest received at a single detector of a heterodyne interferometer or heterodyne interferometer system. The present invention further relates to a heterodyne interferometer or heterodyne interferometer system, a lithographic apparatus and a device manufacturing method making use of such a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

Lithographic apparatus usually include one or more positioning systems to position an object such as a support for a patterning device, a substrate support or an optical element of a projection system or illumination system. Such positioning systems typically include interferometers which may be of the heterodyne type.

In a heterodyne interferometer, a light source is used to create a pair of light beams having a relatively small difference in frequency, which difference in frequency may be referred to as split frequency. A first portion of both light beams is tapped off and both first portions are made to interfere, after which the power of the interference result is detected by a reference detector while a second portion of one of the light beams is allowed to travel along a reference path, and a second portion of the other one of the light beams is allowed to travel along a measurement path. Both second portions are made to interfere and the power of the interference result is detected by a measurement detector. By evaluating an output signal from the measurement detector and comparing this with an output signal from the reference detector, information may be obtained about the optical path length difference of the measurement path and reference path from which position information of a target in the measurement path may be obtained.

A current trend in heterodyne interferometry is to use a plurality of light sources resulting in the use of a plurality of wavelengths to provide respective pairs of light beams having different split frequencies. This increases a capturing range of the heterodyne interferometer and/or increases the accuracy of the obtained position information. However, a drawback of the use of a plurality of wavelengths is that signal separation is required to distinguish information related to one pair of light beams from information related to another pair of light beams. So far, cross-talk has been a limiting factor.

US2014307263 discloses a heterodyne interferometer configured to generate reference light and light to be detected, each light having different frequencies from each other, using first light having a first wavelength and second light having a second wavelength different from the first wavelength, and configured to cause the light to be detected, after reflection from the object, to interfere with the reference light; a first detector configured to detect interference light between the reference light and the light to be detected, and output a measured signal; a second detector configured to detect interference light between the first light and the second light, and output a reference signal; an oscillator configured to generate a standard signal having a frequency corresponding to a frequency shift amount; a first synchronization detector configured to perform synchronous detection of the measured signal output from the first detector and the standard signal generated by the oscillator; a second synchronization detector configured to perform synchronous detection of the reference signal output from the second detector and the standard signal generated by the oscillator; a first processing unit that determines a phase difference between the measured signal and the reference signal based on the outputs of the first synchronization detector and the second synchronization detector; and a second processing unit that determines the position of the object based on the phase difference determined by the first processing unit.

US5106192 discloses a multiple wavelength heterodyne interferometer for measuring a length of an optical path, the length being variable, by simultaneously measuring an optical phase of a plurality of wavelengths or combinations of wavelengths, comprising: means for separating a plurality of light beams into pairs of reference beams and corresponding measurement beams, said light beams each having a distinct wavelength, and said reference and said measurement beams being in random polarization states; means for frequency shifting at least one of said reference and measurement beams of each of said pairs; means for coaxially combining each of said reference beams to form a single, combined reference beam; means for coaxially combining each of said measurement beams to form a single, combined measurement beam; means for directing said combined measurement beam along said optical path; means for combining and interfering said combined reference beam and said combined measurement beam directed along said optical path on a surface of a photodetector to produce distinct differential frequency signals, said combined reference and combined measurement beams being combined and interfered independently of polarization states of said combined reference and combined measurement beams; and means for determining phases or combinations of phases between said differential frequency signals or between combinations of said differential frequency signals.

US2013100458 discloses a multi-wavelength interferometer using at least two light fluxes each having a different wavelength, the multi-wavelength interferometer comprising: a beam splitter configured to split the light fluxes into a reference beam and a measurement beam; a frequency shifter configured to shift a frequency of the reference beam or a frequency of the measurement beam or to shift the frequencies of the reference beam and the measurement beam to make the frequencies of the reference beam and the measurement beam different from each other; an optical system configured to cause the measurement beam to be incident on a measurement surface and to cause the measurement beam reflected from the measurement surface to interfere with the reference beam to obtain interference light, the frequencies of the reference beam and the measurement beam being different from each other by the frequency shifter; a dividing unit configured to divide the interference light into a plurality of light beams; and a detection unit configured to detect the plurality of light beams divided by the dividing unit for each wavelength.

### SUMMARY

Considering the above, it is an object of the invention to provide a heterodyne interferometer or heterodyne interferometer system and corresponding operating method allowing to separate information from a plurality of signals with reduced cross-talk.

According to an embodiment of the invention, there is provided a method to determine one or more signal parameters of each signal of interest in a plurality of signals of interest received at a single detector of a heterodyne interferometer or heterodyne interferometer system or heterodyne encoder system, said method comprising the following steps:
a. for each signal or interest, calculating a cleaned-up signal by estimating signal contributions of the other signals of interest and subtracting these estimated signal contributions from the plurality of signals of interest; and
b. for each signal of interest, determining one or more signal parameters from the respective cleaned-up signal;
wherein the plurality of signals of interest includes signals with different split frequencies.

According to another embodiment of the invention, there is provided a heterodyne interferometer system including:
- a plurality of light sources to provide respective pairs of light beams having different split frequencies;
- a reference detector;
- a measurement detector;
- a beam splitter to split each light beam into a first portion that is directed towards the reference detector and a second portion that is directed towards the measurement detector;
- an optics system configured to allow the second portion of one of the light beams of each pair of light beams to travel along a reference path towards the measurement detector and to allow the second portion of the other one of the light beams of each pair of light beams to travel along a measurement path towards the measurement detector; and
- a processing unit to process an output signal of the reference detector and/or measurement detector comprising a plurality of split frequency signals based on the split frequencies of the respective pairs of light beams,
wherein the processing unit is configured to determine one or more signal parameters of each split frequency signal in the output signal by calculating a cleaned-up signal for each signal of interest by estimating signal contributions of the other signals of interest and subtracting these estimated signal contributions from the plurality of signals of interest, and by determining one or more signal parameters from the respective cleaned-up signal for each signal of interest.

According to a further embodiment of the invention, there is provided a positioning system to determine a position of a target, comprising:
- a measurement system to measure a position of the target;
- an actuator system to move the target; and
- a control unit to drive the actuator system in dependency of the measurement system,
wherein the measurement system comprises a heterodyne interferometer or heterodyne interferometer system or heterodyne encoder system according to the invention.

According to yet another embodiment of the invention, there is provided a lithographic apparatus comprising an object and a positioning system according to the invention.

According to a further embodiment of the invention, there is provided a device manufacturing method wherein use is made of a lithographic apparatus according to the invention.

According to yet another embodiment of the invention, there is provided a heterodyne interferometer or heterodyne interferometer system or heterodyne encoder system comprising at least one detector and an optical system configured to receive a plurality of respective pairs of light beams having different split frequencies and to direct at least a portion of the light beams to the at least one detector so that the detector receives a plurality of signals of interest, wherein the heterodyne interferometer heterodyne interferometer further includes a processing unit configured to determine one or more signal parameters of each split frequency signal in an output signal of the at least one detector by calculating a cleaned-up signal for each signal of interest by estimating signal contributions of the other signals of interest and subtracting these estimated signal contributions from the plurality of signals of interest, and by determining one or more signal parameters from the respective cleaned-up signal for each signal of interest.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus according to an embodiment of the invention;
- Figure 2 depicts a detailed view of a part of the lithographic apparatus of Figure 1;
- Figure 3 schematically depicts a position control system as part of a positioning system according to an embodiment of the invention;
- Figure 4 schematically depicts a heterodyne interferometer or heterodyne interferometer system according to an embodiment of the invention; and
- Figure 5 schematically depicts a signal cleanup method as part of signal parameter determination method according to an embodiment of the invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

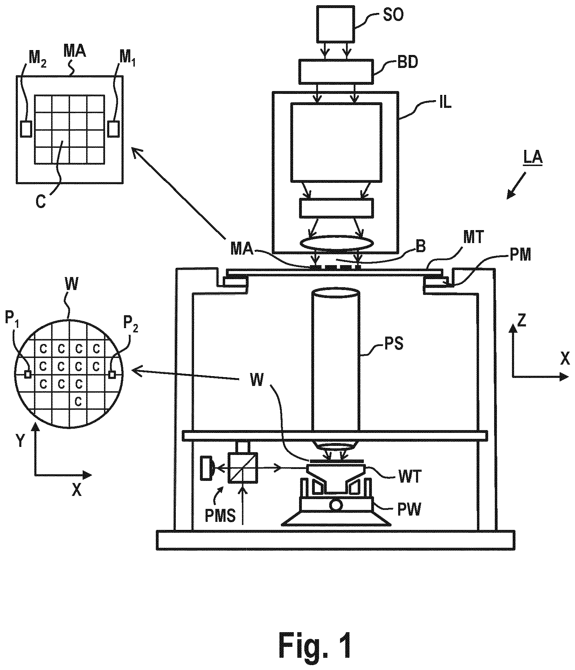

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axis is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

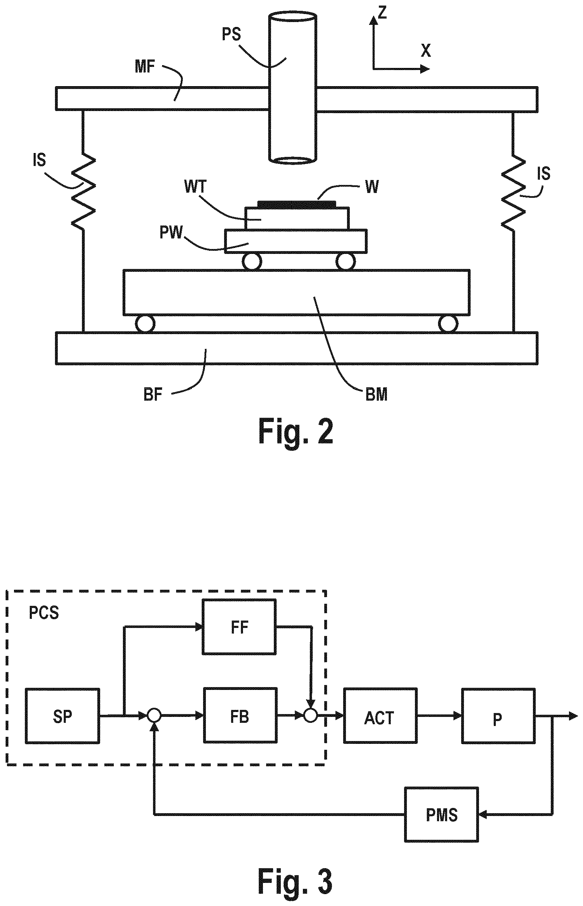

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor. a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electromagnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

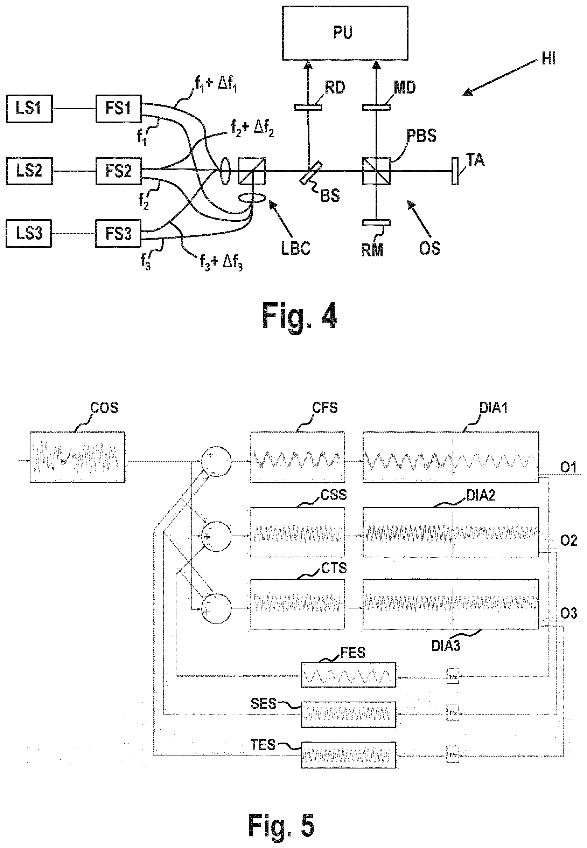

Fig. 4 schematically depicts a heterodyne interferometer or heterodyne interferometer system HI according to an embodiment of the invention as part of the position measurement system PMS mentioned above.

The interferometer HI includes a plurality of light sources, here three light sources LS1, LS2 and LS3. The light sources LS1-LS3 may be laser sources providing a respective coherent light beam of a predetermined frequency.

Each light source LS1-LS3 has an associated frequency shifter FS1, FS2, FS3 outputting a respective pair of light beams indicated by their respective frequencies and resulting in each pair of light beams having a distinct split frequency as indicated below in table 1.

**Table 1: Frequency shifter and light beam overview:**

| Frequency shifter | Frequency of first light beam | Frequency of second light beam | Split frequency |
|---|---|---|---|
| FS1 | f1 | f1 + Δf1 | Δf1 |
| FS2 | f2 | f2 + Δf2 | Δf2 |
| FS3 | f3 | f3 + Δf3 | Δf3 |

The plurality of light beams are combined by optical element LBC, for instance in such a way that each first light beam is orthogonally polarized to the corresponding second light beam, and directed towards a beam splitter BS. The beam splitter BS is configured to split each light beam into a first portion that is directed towards a reference detector RD and a second portion that is directed towards a measurement detector MD via an optics system OS.

The optics system OS is configured to allow the second portion of one of the light beams of each pair of light beams to travel along a reference path towards the measurement detector MD and to allow the second portion of the other one of the light beams of each pair of light beams to travel along a measurement path towards the measurement detector. In the schematic example of Fig. 4, the reference path starts at the beam splitter BS, runs via the polarizing beam splitter PBS to a reference mirror RM, back to the polarizing beam splitter PBS and ends on the measurement detector MD. The measurement path starts at the beam splitter BS, runs via the polarizing beam splitter PBS to a target TA, back to the polarizing beam splitter PBS and ends on the measurement detector MD. Other reference paths and measurement paths are also envisaged. The optics system OS, the beam splitter BS and possibly the optical element LBC, may be referred to as the optical system configured to receive respective pairs of light beams having different split frequencies and to direct at least a portion of the light beams to at least one detector.

It is explicitly noted here that the entire heterodyne interferometer or heterodyne interferometer system, in particular the optics system and the detectors, are depicted highly schematically and elements may have been omitted for clarity reasons. For instance, properly arranged polarization-selective elements before a detector allowing the orthogonally polarized first and second beams interfere at a detector are not separately depicted, nor are any quarter-wave plates depicted that are typically present between the polarizing beam splitter PBS and the target TA and between the polarizing beam splitter PBS and the reference mirror RM. Other optical elements known to the skilled person in the art of heterodyne interferometry may also have been omitted, but may be present for a proper functioning of the heterodyne interferometer or heterodyne interferometer system HI.

A characterizing feature is that the reference path and the measurement path are different so that a difference in the paths can be measured. In case of a moveable target TA, a difference in optical path length can be measured, thereby allowing to measure a position change of the target TA. In case of a static target, a difference in environmental conditions may be measurable, e.g. a change in refractive index, and/or frequency stability of the light sources LS1, LS2 and/or LS3 may be measurable, for instance by measuring a change in wavelength. It is also envisaged that the measurement path is such that the light beam is directed to and reflected by the target multiple times to increase the optical path length and induced difference in optical path length when a displacement of the target TA occurs.

Output signals of the reference detector RD and the measurement detector MD are provided to a processing unit PU. It is also envisaged that a separate processing unit PU is provided per detector RD, MD.

The working principle of the processing unit PU will now be described by reference to Fig. 4. Fig. 4 depicts a diagram COS in a predetermined time frame showing an example of an output signal of a detector of an interferometer, e.g. the detector RD or the detector MD. In this example, the output signal is a combination of three signals having different split frequencies.

The processing unit PU is configured to estimate a signal contribution of the signal with the first split frequency Δf1, to estimate a signal contribution of the signal with the second split frequency Δf2, and to estimate a signal contribution of the signal with the third split frequency Δf3. These estimated signals have been depicted in Fig. 4 in diagrams FES, SES and TES, wherein diagram FES depicts a first estimated signal associated with Δf1, diagram SES depicts a second estimated signal associated with Δf2, and diagram TES depicts a third estimated signal associated with Δf3.

The second and third estimated signals SES, TES are subtracted by the processing unit PU from the output signal COS to obtain a cleaned-up first signal CFS. The first and third estimated signals FES, TES are subtracted by the processing unit PU from the output signal COS to obtain a cleaned-up second signal CSS. The first and second estimated signals FES, SES are subtracted by the processing unit PU from the output signal COS to obtain a cleaned-up third signal CTS. Depending on the quality of the estimated signals, this operation reduces the crosstalk between signals having different split frequencies significantly, so that subsequent operation on the cleaned-up signals to determine one or more signal parameters thereof, such as amplitude, frequency and/or phase, is much more accurate. The subsequent operation is depicted in the diagrams DIA1, DIA2, DIA3, which depicts a curve fit through the cleaned-up signals on the left-side and an extrapolation of the fitted curve on the right side of the respective diagram.

The extrapolations of the fitted curves in diagrams DIA1-DIA3 may be used as basis for the estimated signals FES, SES, TES for a subsequent time frame of the output signal COS. One or more of the signal parameters are used as outputs O1, O2, O3 allowing the processing unit or another control unit to determine a position of other characteristic of the target TA when comparing this signal parameter with a corresponding signal parameter as determined at the other detector, i.e. the reference detector RD or the measurement detector MD.

In an embodiment, a phase-locked and amplitude matched local oscillator may be used to obtain an estimated signal of a signal of interest for a predetermined next time frame.

In an embodiment, the split frequencies Δf1, Δf2, and Δf3 are chosen such that they are orthogonal to each other, thereby allowing to further reduce crosstalk. Split frequencies being orthogonal to each other may mean that the split frequencies are chosen to be separated by exact multiples of 1/T, where T is the sampling period used to the signal parameter. The split frequencies being orthogonal are preferably used for "slow" moving targets, static wavelength trackers with stabilized or only slowly modulating tunable lasers.

In an embodiment, the split frequencies Δf1, Δf2, and Δf3 are chosen such that there is a predetermined minimum difference between any of the split frequencies, so that the split frequencies are sufficiently different, thereby allowing to further reduce crosstalk.

Above, reference has been made to frequency shifters to output pairs of light beams having a distinct split frequency. The split frequencies may for instance be introduced using a Zeeman-split and/or by frequency shifters involving acousto-optical-modulators.

As mentioned before, the method according to the invention may be carried out for a certain time frame. This may be continuously repeated, so that the plurality of signals is processed in sequentially acquired blocks of data. Each block preferably has the same sampling period T. Information, e.g. signal parameters, obtained from previous blocks of data can help for future blocks as will be briefly described below.

When the split frequency and phase of a signal of interest from a previous sample is known, the change of the split frequency at the detector can be determined by comparing a predicted phase with the measured phase of a current block of data. The change of the split frequency is then calculated using (measured phase - predicted phase) / (2πT). With the determined frequency change, a new estimate of the split frequency can be generated.

As an alternative to the above described phaselocking principle, it is also possible to estimate the frequency of a signal of interest by using frequency locking. In such a case, a frequency power spectrum is obtained by taking an FFT transform, or by demodulating a signal over a range of frequencies, e.g. a frequency sweep of the demodulation signal. The measured amplitude can then be determined as a function of frequency. The absolute frequencies in a plurality of signals can then be obtained by a fit or search algorithm for detecting a local maximum in a predefined frequency search region of the frequency power spectrum. When there is no previous estimated frequency known, the demodulation frequency may be swept over a broad search area until a local maximum is found. When a good estimation of the frequency is available, then the search region to find a local maximum of the frequency power spectrum may be narrowed down to a frequency range that is very close to the last known frequency as an initial estimate. As an example, a parabolic fit may be used to get closer to the true value of the frequency where the maximum power is found. Optionally, the frequency estimation may be improved by an iterative approach, e.g. by narrowing down the frequency search range for each iteration. When the power peak has a symmetric shape, a parabolic estimate should iterate to an exact solution. Other improvements may use a better matching goal function instead of a parabolic shape when the power peak has an asymmetric shape.

When the frequency of a signal of interest is known, the phase and amplitude of a cleaned-up signal of interest can be demodulated by mixing said signal with the cosine and sine versions of said signal. After an integrating step over a period T, cosine and sine terms can be obtained from which the phase may be derived via a Cartesian to polar coordinate transformation.

To make the phase determination less sensitive to estimation errors of the frequency and less sensitive to residual crosstalk of other signals of interest, a filter may be applied, e.g. a hanning-like filter. A further improvement may be obtained by introducing higher order (e.g. parabolic) phase extrapolation taking into account a frequency change in between batch samples.

Although the above description relates to multiwavelength heterodyne interferometers, the invention may also apply to other situations in which one detector receives a plurality of signals of interest that have a frequency that are close to each other and need to be separated while minimizing crosstalk, such as heterodyne encoder systems.

Although in the above examples, three different split frequencies have been used, it will be understood that the invention can be applied to any plurality of signals, e.g. using two different split frequencies, but also to applications using more than three split frequencies.

Although reference has been made both to a heterodyne interferometer and a heterodyne interferometer system, it will be understood that these two terms may be interchangeable depending on what elements are considered to be part of the heterodyne interferometer and what elements are considered to be external components that are part of the heterodyne interferometer system but not of the heterodyne interferometer as there is no clear definition.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method to determine one or more signal parameters of each signal of interest in a plurality of signals of interest received at a single detector of a heterodyne interferometer, said method being **characterized in that** it comprises the following steps:
a. for each signal of interest, calculating a cleaned-up signal by estimating signal contributions of the other signals of interest and subtracting these estimated signal contributions from the plurality of signals of interest; and
b. for each signal of interest, determining one or more signal parameters from the respective cleaned-up signal;
wherein the plurality of signals of interest includes signals with different split frequencies.

2. A method according to claim 1, wherein the method is carried out on the plurality of signals of interest for a predetermined time frame.

3. A method according to claim 2, wherein the method is repeated for a plurality of different time frames to determine the one or more signal parameters as a function of time.

4. A method according to claim 3, wherein at least one of the one or more signal parameters determined for one time frame is used to estimate the signal contribution of the respective signal of interest for another time frame.

5. A method according to any of claims 1-4, wherein the different split frequencies are orthogonal to each other.

6. A method according to any of claims 1-5, wherein the one or more signal parameters include phase, amplitude and/or frequency of the signal of interest.

7. A heterodyne interferometer system (HI) including:
- a plurality of light sources (LS1, LS2, LS3) to provide respective pairs of light beams having different split
frequencies;
- a reference detector (RD);
- a measurement detector (MD);
- a beam splitter (BS) to split each light beam into a first portion that is directed towards the reference detector and a second portion that is directed towards the measurement detector;
- an optics system (OS) configured to allow the second portion of one of the light beams of each pair of light beams to travel along a reference path towards the measurement detector and to allow the second portion of the other one of the light beams of each pair of light beams to travel along a measurement path towards the measurement detector; and
- a processing unit (PU) to process an output signal (COS) of the reference detector and/or measurement detector comprising a plurality of split frequency signals based on the split frequencies of the respective pairs of light beams,
wherein the processing unit is configured to determine one or more signal parameters of each split frequency signal in the output signal by calculating a cleaned-up signal (CFS, CSS, CTS) for each signal of interest by estimating signal contributions (FES, SES, TES) of the other signals of interest and subtracting these estimated signal contributions from the plurality of signals of interest, and by determining one or more signal parameters from the respective cleaned-up signal for each signal of interest.

8. A heterodyne interferometer system according to claim 7, wherein the processing unit is configured to determine one or more signal parameters of each split frequency signal in the output signal of the reference detector and is configured to determine one or more signal parameters of each split frequency signal in the output signal of the measurement detector.

9. A heterodyne interferometer system according to claim 7 or 8, wherein the measurement path includes a moveable target (TA), and wherein the heterodyne interferometer system is configured to determine a position of the moveable target from the determined one or more signal parameters.

10. A heterodyne interferometer system according to claim 7 or 8, wherein the measurement path and/or the reference path include a static length-stabilized cavity, and wherein the processing unit is configured to determine a change in the refractive index of the medium the light beams are travelling through and/or a light source frequency stability from the determined one or more signal parameters.

11. A positioning system to determine a position of a target, comprising:
- a measurement system to measure a position of the target;
- an actuator system to move the target; and
- a control unit to drive the actuator system in dependency of the measurement system,
wherein the measurement system comprises a heterodyne interferometer system according to any of claims 7-10.

12. A positioning system according to claim 11, wherein the measurement system comprises a heterodyne interferometer system according to claim 9.

13. A lithographic apparatus comprising:
- an object; and
- a positioning system according to claim 11 or 12, wherein the object is the target.

14. A device manufacturing method wherein use is made of a lithographic apparatus according to claim 13.

## Patentansprüche

1. Ein Verfahren zum Bestimmen eines oder mehrerer Signalparameter jedes Signals von Interesse in einer Vielzahl von Signalen von Interesse, die an einem einzelnen Detektor eines Heterodyninterferometers empfangen werden, wobei das Verfahren **dadurch gekennzeichnet ist, dass** es die folgenden Schritte beinhaltet:
a. für jedes Signal von Interesse, Berechnen eines bereinigten Signals durch das Schätzen von Signalbeiträgen der anderen Signale von Interesse und Subtrahieren dieser geschätzten Signalbeiträge von der Vielzahl von Signalen von Interesse; und
b. für jedes Signal von Interesse, Bestimmen eines oder mehrerer Signalparameter aus dem jeweiligen bereinigten Signal;
wobei die Vielzahl von Signalen von Interesse Signale mit unterschiedlichen Aufspaltungsfrequenzen umfasst.

2. Verfahren gemäß Anspruch 1, wobei das Verfahren für einen vorgegebenen Zeitrahmen an der Vielzahl von Signalen von Interesse ausgeführt wird.

3. Verfahren gemäß Anspruch 2, wobei das Verfahren für eine Vielzahl von unterschiedlichen Zeitrahmen wiederholt wird, um den einen oder die mehreren Signalparameter als eine Funktion der Zeit zu bestimmen.

4. Verfahren gemäß Anspruch 3, wobei mindestens einer von dem einen oder den mehreren für einen Zeitrahmen bestimmten Signalparametern verwendet wird, um den Signalbeitrag des jeweiligen Signals von Interesse für einen weiteren Zeitrahmen zu schätzen.

5. Verfahren gemäß einem der Ansprüche 1-4, wobei die unterschiedlichen Aufspaltungsfrequenzen zueinander orthogonal sind.

6. Verfahren gemäß einem der Ansprüche 1-5, wobei der eine oder die mehreren Signalparameter Phase, Amplitude und/oder Frequenz des Signals von Interesse umfassen.

7. Ein Heterodyninterferometersystem (HI), das Folgendes umfasst:
- eine Vielzahl von Lichtquellen (LS1, LS2, LS3), um jeweilige Paare von Lichtstrahlen mit unterschiedlichen Aufspaltungsfrequenzen bereitzustellen;
- einen Bezugsdetektor (RD);
- einen Messdetektor (MD);
- einen Strahlspalter (BS), um jeden Lichtstrahl in einen ersten Anteil, der auf den Bezugsdetektor gerichtet wird, und einen zweiten Anteil, der auf den Messdetektor gerichtet wird, zu spalten;
- ein Optiksystem (OS), das konfiguriert ist, um zu ermöglichen, dass der zweite Anteil eines der Lichtstrahlen jedes Paars von Lichtstrahlen entlang eines Bezugsweges zu dem Messdetektor geht, und um zu ermöglichen, dass der zweite Anteil des anderen der Lichtstrahlen jedes Paares von Lichtstrahlen entlang eines Messweges zu dem Messdetektor geht; und
- eine Verarbeitungseinheit (PU), um ein Ausgangssignal (COS) des Bezugsdetektors und/oder Messdetektors zu verarbeiten, das eine Vielzahl von Aufspaltungsfrequenzsignalen auf der Basis der Aufspaltungsfrequenzen der jeweiligen Paare von Lichtstrahlen beinhaltet,
wobei die Verarbeitungseinheit konfiguriert ist, um einen oder mehrere Signalparameter jedes Aufspaltungsfrequenzsignals in dem Ausgangssignal durch das Berechnen eines bereinigten Signals (CFS, CSS, CTS) für jedes Signal von Interesse durch das Schätzen von Signalbeiträgen (FES, SES, TES) der anderen Signale von Interesse und das Subtrahieren dieser geschätzten Signalbeiträge von der Vielzahl von Signalen von Interesse und durch das Bestimmen eines oder mehrerer Signalparameter aus dem jeweiligen bereinigten Signal für jedes Signal von Interesse zu bestimmen.

8. Heterodyninterferometersystem gemäß Anspruch 7, wobei die Verarbeitungseinheit konfiguriert ist, um einen oder mehrere Signalparameter jedes Aufspaltungsfrequenzsignals in dem Ausgangssignal des Bezugsdetektors zu bestimmen, und konfiguriert ist, um einen oder mehrere Signalparameter jedes Aufspaltungsfrequenzsignals in dem Ausgangssignal des Messdetektors zu bestimmen.

9. Heterodyninterferometersystem gemäß Anspruch 7 oder 8, wobei der Messweg ein bewegliches Ziel (TA) umfasst und wobei das Heterodyninterferometersystem konfiguriert ist, um aus dem einen oder den mehreren bestimmten Signalparametern eine Position des beweglichen Ziels zu bestimmen.

10. Heterodyninterferometersystem gemäß Anspruch 7 oder 8, wobei der Messweg und/oder der Bezugsweg einen statisch-längenstabilisierten Hohlraum umfassen und wobei die Verarbeitungseinheit konfiguriert ist, um eine Änderung des Brechungsindex des Mediums, durch das die Lichtstrahlen gehen, und/oder eine Lichtquellenfrequenzstabilität aus dem einen oder den mehreren bestimmten Signalparametern zu bestimmen.

11. Ein Positionierungssystem, um eine Position eines Ziels zu bestimmen, das Folgendes beinhaltet:
- ein Messsystem, um eine Position des Ziels zu messen,
- ein Aktorsystem, um das Ziel zu bewegen; und
- eine Steuereinheit, um das Aktorsystem abhängig von dem Messsystem anzutreiben, wobei das Messsystem ein Heterodyninterferometersystem gemäß einem der Ansprüche 7-10 beinhaltet.

12. Positionierungssystem gemäß Anspruch 11, wobei das Messsystem ein Heterodyninterferometersystem gemäß Anspruch 9 beinhaltet.

13. Ein lithographisches Gerät, das Folgendes beinhaltet:
- ein Objekt; und
- ein Positionierungssystem gemäß Anspruch 11 oder 12, wobei das Objekt das Ziel ist.

14. Ein Verfahren zum Herstellen einer Vorrichtung, wobei ein lithographisches Gerät gemäß Anspruch 13 verwendet wird.

## Revendications

1. Un procédé pour déterminer un ou plusieurs paramètres de signal de chaque signal d'intérêt dans une pluralité de signaux d'intérêt reçus au niveau d'un détecteur unique d'un interféromètre hétérodyne, ledit procédé étant **caractérisé en ce qu'**il comprend les étapes suivantes :
a. pour chaque signal d'intérêt, calculer un signal nettoyé en estimant des contributions de signal des autres signaux d'intérêt et en soustrayant ces contributions de signal estimées de la pluralité de signaux d'intérêt ; et
b. pour chaque signal d'intérêt, déterminer un ou plusieurs paramètres de signal à partir du signal nettoyé respectif ;
où la pluralité de signaux d'intérêt incluent des signaux avec différentes fréquences séparées.

2. Un procédé selon la revendication 1, où le procédé est effectué sur la pluralité de signaux d'intérêt pendant une trame temporelle prédéterminée.

3. Un procédé selon la revendication 2, où le procédé est répété pour une pluralité de trames temporelles différentes afin de déterminer les un ou plusieurs paramètres de signal en fonction du temps.

4. Un procédé selon la revendication 3, où au moins un des un ou plusieurs paramètres de signal déterminés pour une trame temporelle est utilisé pour estimer la contribution de signal du signal d'intérêt respectif pour une autre trame temporelle.

5. Un procédé selon n'importe lesquelles des revendications 1 à 4, où les différentes fréquences séparées sont orthogonales les unes aux autres.

6. Un procédé selon n'importe lesquelles des revendications 1 à 5, où les un ou plusieurs paramètres de signal incluent la phase, l'amplitude et/ou la fréquence du signal d'intérêt.

7. Un système interféromètre hétérodyne (HI) incluant :
- une pluralité de sources de lumière (LS1, LS2, LS3) pour fournir des paires de faisceaux de lumière respectives ayant différentes fréquences séparées ;
- un détecteur de référence (RD) ;
- un détecteur de mesure (MD) ;
- un séparateur de faisceau (BS) pour séparer chaque faisceau de lumière en une première portion qui est dirigée vers le détecteur de référence et une deuxième portion qui est dirigée vers le détecteur de mesure ;
- un système d'optique (OS) configuré pour permettre à la deuxième portion d'un des faisceaux de lumière de chaque paire de faisceaux de lumière de progresser le long d'un chemin de référence vers le détecteur de mesure et pour permettre à la deuxième portion de l'autre des faisceaux de lumière de chaque paire de faisceaux de lumière de progresser le long d'un chemin de mesure vers le détecteur de mesure ; et
- une unité de traitement (PU) pour traiter un signal de sortie (COS) du détecteur de référence et/ou du détecteur de mesure comprenant une pluralité de signaux de fréquences séparées basés sur les fréquences séparées des paires de faisceaux de lumière respectives,
où l'unité de traitement est configurée pour déterminer un ou plusieurs paramètres de signal de chaque signal de fréquence séparée dans le signal de sortie en calculant un signal nettoyé (CFS, CSS, CTS) pour chaque signal d'intérêt en estimant des contributions de signal (FES, SES, TES) des autres signaux d'intérêt et en soustrayant ces contributions de signal estimées de la pluralité de signaux d'intérêt, et en déterminant un ou plusieurs paramètres de signal à partir du signal nettoyé respectif pour chaque signal d'intérêt.

8. Un système interféromètre hétérodyne selon la revendication 7, où l'unité de traitement est configurée pour déterminer un ou plusieurs paramètres de signal de chaque signal de fréquence séparée dans le signal de sortie du détecteur de référence et est configurée pour déterminer un ou plusieurs paramètres de signal de chaque signal de fréquence séparée dans le signal de sortie du détecteur de mesure.

9. Un système interféromètre hétérodyne selon la revendication 7 ou la revendication 8, où le chemin de mesure inclut une cible mobile (TA), et où le système interféromètre hétérodyne est configuré pour déterminer une position de la cible mobile à partir des un ou plusieurs paramètres de signal déterminés.

10. Un système interféromètre hétérodyne selon la revendication 7 ou la revendication 8, où le chemin de mesure et/ou le chemin de référence incluent une cavité stabilisée en longueur statique, et où l'unité de traitement est configurée pour déterminer un changement dans l'indice de réfraction du milieu que traversent les faisceaux de lumière lors de leur progression et/ou une stabilité en fréquence de source de lumière à partir des un ou plusieurs paramètres de signal déterminés.

11. Un système de positionnement pour déterminer une position d'une cible, comprenant :
- un système de mesure pour mesurer une position de la cible ;
- un système actionneur pour déplacer la cible ; et
- une unité de commande pour entraîner le système actionneur en fonction du système de mesure,
où le système de mesure comprend un système interféromètre hétérodyne selon n'importe lesquelles des revendications 7 à 10.

12. Un système de positionnement selon la revendication 11, où le système de mesure comprend un système interféromètre hétérodyne selon la revendication 9.

13. Un appareil lithographique comprenant :
- un objet ; et
- un système de positionnement selon la revendication 11 ou la revendication 12, où l'objet est la cible.

14. Un procédé de fabrication de dispositif où il est fait usage d'un appareil lithographique selon la revendication 13.
